# EUROPEAN PATENT APPLICATION

(11) **EP 2 682 442 A1**
(43) Date of publication of application: **08.01.2014**
(21) Application number: 12751923.9
(22) Date of filing: 01.03.2012
(51) Int. Cl.: C09J 7/02, B32B 27/00, C09J 11/08, C09J 201/00, H01L 21/301

(54) **HEAT-PEELABLE ADHESIVE SHEET**

(30) Priority: 03.03.2011 JP 2011046864
(71) Applicant: Nitto Denko Corporation, Ibaraki-shi, Osaka 567-8680 (JP)
(72) Inventor: TAKAMI Yoshihito, Ibaraki-shi Osaka 567-8680 (JP); SHIMOKAWA Daisuke, Ibaraki-shi Osaka 567-8680 (JP); MURATA Akihisa, Ibaraki-shi Osaka 567-8680 (JP)
(74) Representative: Grünecker, Kinkeldey, Stockmair & Schwanhäusser
(86) International application number: PCT/JP2012/055250
(87) International publication number: WO 2012/118152

(57) **Abstract**

When a heat-peelable adhesive sheet is used, there has been the case in which the heat-peelable adhesive sheet is wrongly used that is scheduled to be used differently according to a difference among workpieces, a difference among the steps, and the like. For this reason, it has been necessary to clearly check a usable heat-peelable adhesive sheet according to the differences among the workpieces or among the steps, so as not to cause such an error. In addition, when the heat-peelable adhesive sheet is transparent and colorless, it has been difficult to check whether the adhesive sheet has been accurately stuck on the workpiece. A heat-peelable adhesive sheet of which the tackiness agent layer is merely colored has had a possibility of polluting electronic components and giving damage to the electronic components, by the deposition of metal ions originating in the coloring agent onto a surface of the workpiece such as the electronic components. In order to solve these problems, a heat-peelable adhesive sheet is provided which includes a thermally expansive pressure-sensitive adhesive layer that contains thermally expansive microspheres and the coloring agent and that is provided on one side or both sides of the substrate, or a thermally expansive pressure-sensitive adhesive layer that contains thermally expansive microspheres and is provided on one side or both sides of the substrate through a colored intermediate layer, and which has a total light transmittance of 50% or more.

## Description

### [Technical Field]

The present invention relates to a heat-peelable adhesive sheet.

### [Background Art]

In processing such as dicing and back grinding of semiconductor wafers, processing such as cutting in the manufacture of electronic components, and processing of optical components and the like, workpieces are securely pressure-sensitively adhered to a heat-peelable adhesive sheet and thereby unified therewith; and in processing thereof, the processing is tried to be smoothly advanced by fixing the workpieces to processing machines through the heat-peelable adhesive sheet.

In processing such workpieces, a step is needed in which the workpieces are fixed on a tackiness agent layer of the heat-peelable adhesive sheet.

In this step, a suitable heat-peelable adhesive sheet will be selected depending on the type of workpieces. At this time, these heat-peelable adhesive sheets are common in the point of a transparent and colorless sheet shape; and when packaged rolls of heatpeelable adhesive sheets are new, a heat-peelable adhesive sheet can be selected depending on the kind of a workpiece even when plural kinds of heat-peelable adhesive sheets are present, because item numbers and the like are displayed on the packaging materials.

However, once rolls of plural kinds of heat-peelable adhesive sheets are taken out from the packaging materials, the kinds cannot be distinguished in appearance because item numbers and the like are not shown on the rolls themselves; a distinction cannot be made between the plural kinds of heat-peelable adhesive sheets, leading to a possibility that another heat-peelable adhesive sheet is erroneously selected to prevent from using a heat-peelable adhesive sheet appropriate for a workpiece.

Further since the heat-peelable adhesive sheets are transparent and colorless, the heat-peelable adhesive sheets have poor sticking visibility and thus cannot be stuck accurately depending on workpieces upon sticking on the workpieces.

As shown in Patent Literature 1, it is known that in a heat-peelable adhesive sheet in which a black or blue to green coloring agent, which is a infrared absorbent substance, is added to a foaming tackiness agent layer to impart infrared absorbency, efficient heat generation and peeling by absorption of infrared rays are carried out due to the coloring.

However, such coloring does not have a purpose of changing coloring of heat-peelable adhesive sheets for each different item numbers, but has a purpose of imparting the same coloring for every heat-peelable adhesive sheet to be thermally foamed. Then, this finally results in carrying out the same coloring on heat-peelable adhesive sheets of each item number, resulting in being unable to distinguish between heat-peelable adhesive sheets when the heat-peelable adhesive sheets are selected corresponding to workpieces. In order to absorb infrared rays, heat-peelable adhesive sheets are those having low light transmission through which light scarcely transmits.

As shown in Patent Literature 2, incorporation of a thermochromic microspheric pigment in a thermally expansive pressure-sensitive adhesive layer of a heatpeelable adhesive sheet is well-known; however, since the thermochromic microspheric pigment is incorporated in order to check whether the pressure-sensitive adhesive sheet has been uniformly heated, and the heat-peelable adhesive sheet is transparent and colorless before the thermally expansive pressure-sensitive adhesive layer is thermally expanded, that is, before the heat-peelable adhesive sheet is used, changing the color of the heat-peelable tackiness agent layer for each item number is not carried out before the heat-peelable adhesive sheet is used.

### [Citation List]

### [Patent Literature]

[Patent Literature 1]
   Japanese Patent No. 4010643
[Patent Literature 2]
   Japanese Patent Laid-Open No. 2003-160767

### [Summary of Invention]

### [Technical Problem]

When a heat-peelable adhesive sheet is used, there has been the caste in which the heat-peelable Adhesive sheet is wrongly used that is scheduled to be used differently according to a difference among workpieces, a difference among the steps, and the like. For this reason, it has been necessary to clearly check a usable heat-peelable adhesive sheet according to the differences among the workpieces or among the steps, so as not to cause such an error. In addition, when the heat-peelable adhesive sheet is transparent and colorless, it has been difficult to check whether the adhesive sheet has been accurately stuck on the workpiece.

A heat-peelable adhesive sheet of which the tackiness agent layer is merely colored has had a possibility of polluting electronic components and giving damage to the electronic components, by the deposition of metal ions originating in the coloring agent onto a surface of the workpiece such as the electronic components.

### [Solution to Problem]

Then, the present inventors have aimed at the improvement of the distinguishability and the visibility of a heat-peelable adhesive sheet and the reduction of the pollution with metal ions, by incorporating a pigment in a heat-peelable layer of the heat-peelable adhesive sheet and further making the amount of the pigment added to be a suitable amount.

Specifically,
1. A heat-peelable adhesive sheet, comprising:
   a thermally expansive pressure-sensitive adhesive layer that contains a thermally expansive microsphere and a coloring agent and that is provided on one side or both sides of a substrate; or
   a thermally expansive pressure-sensitive adhesive layer that contains a thermally expansive microsphere and that is provided on one side or both sides of a substrate through a colored intermediate layer, and
   having a total light transmittance of 50% or more.
2. The heat-peelable adhesive sheet described in 1, wherein an amount of metal transferred to a workpiece after the heat-peelable adhesive sheet is stuck on a workpiece and peeled from the workpiece is 1.0 × 10¹⁰ atoms/cm² or lower as a measurement value by an inductively coupled plasma mass spectroscopy.
3. The heat-peelable adhesive sheet described in 1 and 2, wherein an amount of metal transferred to a workpiece after the heat-peelable adhesive sheet is stuck on a workpiece, is left at 40°C for 1 day, and thereafter thermally peeled from the workpiece is 1.0 × 10¹⁰ atoms/cm² or lower as a measurement value by an inductively coupled plasma mass spectroscopy.

### [Advantageous Effects of Invention]

In the present invention, in the case where plural kinds of workpieces are processed by using the heatpeelable adhesive sheet according to the present invention, whose tape's distinguishability has been improved by adding a pigment, a heat-peelable adhesive sheet different in color for each kind of the workpieces is prepared corresponding to the workpiece. If the processing of the workpiece is carried out after such a preparation, since the heat-peelable adhesive sheet suitable for the workpiece can be imparted with the distinguishability in use thereof, and can be used correctly, the workpiece can be processed more securely. Additionally, when the heat-peelable adhesive sheet is stuck on a workpiece, it is easy to check whether accurate sticking has been carried out by the colored heat-peelable adhesive sheet.

Additionally, the influence on electronic components (workpieces) is reduced by limiting the amount of metal ions by regulation of the amount added. Further, the amount of metal transferred from a thermally expansive pressure-sensitive adhesive layer to a workpiece after the heat-peelable adhesive sheet according to the present invention is stuck and peeled is not more than a specific value, which is a small value, also having an effect of preventing adverse influences such as short and the like of electronic components due to metal ions.

### [Brief Description of Drawings]

[Figure 1] Figure 1 is the heat-peelable adhesive sheet according to the present invention.
[Figure 2] Figure 2 is another example of the heat-peelable adhesive sheet according to the present invention.
[Figure 3] Figure 3 is an example of use of the heat-peelable adhesive sheet according to the present invention.

### [Reference Signs List]

- 1: SUBSTRATE
- 2: INTERMEDIATE LAYER
- 2a: CURED INTERMEDIATE LAYER AFTER IRRADIATION OF ENERGY RAYS
- 3: THERMALLY EXPANSIVE PRESSURE-SENSITIVE ADHESIVE LAYER
- 3a: THERMALLY EXPANSIVE PRESSURE-SENSITIVE ADHESIVE LAYER AFTER EXPANSION OF THERMALLY EXPANSIVE MICROSPHERE
- 4: SEPARATOR
- 5: ADHESIVE AGENT LAYER
- 6: SEPARATOR
- 7: WORKPIECE
- 7a: CUT PIECE
- 8: ENERGY RAYS
- 9: CUTTING LINE

### [Description of Embodiments]

The heat-peelable adhesive sheet according to the present invention comprising a thermally expansive pressure-sensitive adhesive layer containing a thermally expansive microsphere and a coloring agent provided on one side or both sides of a substrate, and having a total light transmittance of 50% or more, is used to fix wafers, electronic components and the like when these are processed.

As means of making the total light transmittance to be 50% or more, a colored film may be used as a substrate film, but since any commercially available film capable of being used as a substrate film is transparent and colorless and otherwise, the substrate film cannot be used for distinguishing by color.

Further, a purpose of the present invention is to enable prevention of adverse influences of metal ions on electronic components because the amount of metal transferred from a thermally expansive pressure-sensitive adhesive layer to a workpiece such as electronic components after the heat-peelable adhesive sheet is stuck and peeled is not more than a specific value, which is a low value.

In the case where plural kinds of workpieces are processed by using the heat-peelable adhesive sheet according to the present invention, a heat-peelable adhesive sheet different in color for each kind of the workpieces is prepared corresponding to the workpiece. Since when the heat-peelable adhesive sheet is stuck on a workpiece to process the workpiece after such a preparation, the heat-peelable adhesive sheet suitable for the workpiece has the distinguishability, and can be used in no error, the workpiece can be processed more securely. Additionally, when the heat-peelable adhesive sheet is stuck on a workpiece, it is easy to check whether accurate sticking has been carried out by the colored heat-peelable adhesive sheet, which is a purpose of the present invention.

Therefore, as described above, the heat-peelable adhesive sheet is made one comprising a thermally expansive pressure-sensitive adhesive layer that contains thermally expansive microspheres and the coloring agent and that is provided on one side or both sides of the substrate, or a thermally expansive pressure-sensitive adhesive layer that contains thermally expansive microspheres and is provided on one side or both sides of the substrate through a colored intermediate layer, and which has a total light transmittance of 50% or more.

The heat-peelable adhesive sheet comprises as a fundamental structure a substrate and a thermally expansive pressure-sensitive adhesive layer containing a thermally expansive microsphere and a coloring agent, and the thermally expansive pressure-sensitive adhesive layer containing a thermally expansive microsphere and a coloring agent may be provided on one side or both sides of the substrate. In the case of being provided on one side of the substrate, an adhesive agent layer may be provided on the other side thereof. When electronic components are processed, the heat-peelable adhesive sheet having the thermally expansive pressure-sensitive adhesive layer on which the electronic components are fixed is mounted on a stage of a processing apparatus, and the heat-peelable adhesive sheet can be fixed to the stage through the adhesive agent layer of the other side of the substrate.

Of course, the adhesive agent layer does not necessarily need to be formed on the other side of the substrate; in this case, the heat-peelable adhesive sheet having the thermally expansive pressure-sensitive adhesive layer on which electronic components are fixed may be fixed by fixing means, for example, a vacuum chuck, provided on a stage of a processing apparatus.

The heat-peelable adhesive sheet according to the present invention may be provided with a separator to protect a thermally expansive pressure-sensitive adhesive layer, a substrate or a tackiness agent layer located on the surface.

Hereinafter, each layer constituting the heat-peelable adhesive sheet according to the present invention will be described.

### [Substrate]

A substrate 1 becomes a supporting base body for an intermediate layer 2 or the like, and a substrate is used which has a heat resistance in such a degree that mechanical properties are not damaged by a heat treatment of a thermally expansive pressure-sensitive adhesive layer 3.

Examples of such a substrate 1 include plastic films and sheets of polyesters, olefinic resins, polyvinyl chlorides or the like, but are not limited thereto.

The substrate 1 preferably has the cutting property to cutting means such as a cutter used in cutting workpieces. In the case where a substrate of a soft polyolefin film or sheet having the heat resistance and the stretchability is used as the substrate 1, if a cutting blade enters up to a midway of the substrate in a step of cutting workpieces, since the substrate can be elongated later, the material is suitable for a cut-piece recovery system necessitating causing gaps between cut pieces.

In the case where the intermediate layer 2 is made to be composed of an energy-ray curing type resin layer, since energy rays are used when the layer is cured, the substrate 1 (or the thermally expansive pressure-sensitive adhesive layer 3 or the like) needs to be constituted of a material capable of transmitting a predetermined or more amount of energy rays. The substrate 1 may be of a single layer or a multilayer. Alternatively, the substrate 1 is subjected to a surface treatment with a suitable peeling agent described later; an energy-ray curing type resin layer is formed on the treated surface; thereafter, the energy-ray curing type and heat-peelable adhesive sheet is irradiated with energy rays to cure the energy-ray curing type resin layer; and thereafter, the substrate 1 is peeled, thus also allowing thickness reduction of the energy-ray curing type and heat-peelable adhesive sheet itself.

The thickness of the substrate 1 can suitably be selected in the range not damaging the operability and the workability in each step of sticking workpieces, cutting workpieces, peeling and recovering cut pieces, and the like, but is usually 500 µm or smaller, preferably about 3 to 300 µm, and more preferably about 5 to 150 µm.

The surface of the substrate 1, in order to enhance the tight adhesiveness, the retention performance and the like with an adjacent layer, may be subjected to commonly-used surface treatments, for example, chemical or physical treatments such as chromic acid treatment, ozone exposure, flame exposure, high-voltage shock exposure and ionizing radiation treatment, and coating treatments with an undercoating agent (for example, a tacky substance described later).

### [Thermally expansive pressure-sensitive adhesive layer]

The thermally expansive pressure-sensitive adhesive layer 3 contains a tacky substance to impart the pressure-sensitive adhesiveness and a thermally expansive microsphere to impart the thermal expansiveness.

The thermally expansive pressure-sensitive adhesive layer is a layer to make the peeling easy by reduction of the adhesive area due to foaming of a foaming agent by heat, and the foaming agent to be used is a thermally expansive microsphere. The foaming agent may be used singly or in combinations of two or more.

The thermally expansive microsphere can suitably be selected from well-known thermally expansive microspheres. In the case where the thermally expansive microsphere is a non-microcapsulated foaming agent, since the good peelability cannot stably be developed in some cases, a microcapsulated foaming agent can suitably be used.

The tacky substance to be used is one having elasticity in a degree allowing and not confining foaming and/or expansion of the thermally expansive microsphere during heating. Therefore, conventionally well-known tackiness agents and the like can be used. Examples of the tackiness agent include rubbery tackiness agents such as natural rubber and various kinds of synthetic rubbers, silicone-based tackiness agents, acrylic tackiness agents (for example, an acrylic tackiness agent described as a base material of the energy-ray curing type resin layer 2) such as copolymers of alkyl (meth)acrylates and other unsaturated monomers copolymerizable with the esters, vinyl alkyl etheric tackiness agents, polyesteric tackiness agents, polyamide-based tackiness agents, urethanic tackiness agents and styrene-diene block copolymer-based tackiness agents.

These tackiness agents can be used further in combination with one or more of well-known tackiness agents such as ones having improved creeping characteristics in which heat melting resins having a melting point of about 200°C or lower are blended (see, for example, Japanese Patent Laid-Open Nos. 56-61468, 61-174857, 63-17981 and 56-13040).

For the thermally expansive pressure-sensitive adhesive layer 3, an energy-ray curing type tackiness agent may be used. In this case, if the dynamic elastic modulus after the irradiation of energy rays is 1 × 10⁵ to 5 × 10⁷ Pa (frequency: 1 Hz, sample: film-shape of 1.5 mm in thickness) in a shear storage elastic modulus in the temperature range where the thermally expansive microsphere starts to expand, the good peelability can be provided.

Then above all, use of an acrylic tackiness agent is preferable from the viewpoint of the pressure-sensitive adhesiveness.

### (Detailed description of an acrylic tackiness agent composition)

As the acrylic tackiness agent described above, usable is an acrylic tackiness agent and the like containing as a base polymer an acrylic polymer (homopolymer or copolymer) using as a monomer component(s) one or two or more of alkyl (meth)acrylates (for example, C₁₋₂₀ alkyl esters such as methyl ester, ethyl ester, propyl ester, isopropyl ester, butyl ester, isobutyl ester, s-butyl ester, t-butyl ester, pentyl ester, hexyl ester, heptyl ester, octyl ester, 2-ethylhexyl ester, isooctyl ester, isodecyl ester, dodecyl ester, tridecyl ester, pentadecyl ester, hexadecyl ester, heptadecyl ester, octadecyl ester, nonadecyl ester and eicosyl ester).

The acrylic polymer described above, for the purpose of the modification of the cohesive force, heat resistance, crosslinking property and the like, as required, may contain units corresponding to other monomer components copolymerizable with the alkyl (meth)acrylates. Examples of such a monomer component include carboxyl group-containing monomers such as acrylic acid, methacrylic acid, carboxyethyl acrylate, carboxypentyl acrylate, itaconic acid, maleic acid, fumaric acid and crotonic acid; acid anhydride monomers such as maleic anhydride and itaconic anhydride; hydroxyl group-containing monomers such as hydroxyethyl (meth)acrylate, hydroxypropyl (meth)acrylate, hydroxybutyl (meth)acrylate, hydroxyhexyl (meth)acrylate, hydroxyoctyl (meth)acrylate, hydroxydecyl (meth)acrylate, hydroxylauryl (meth)acrylate and (4-hydroxymethylcyclohexyl)methyl methacrylate; sulfonic acid group-containing monomers such as styrenesulfonic acid, allylsulfonic acid, 2-(meth)acrylamide-2-methylpropanesulfonic acid, (meth)acrylamidepropanesulfonic acid, sulfopropyl (meth)acrylate and (meth)acryloyloxynaphthalenesulfonic acid; (N-substituted) amide-based monomers such as (meth)acrylamide, N,N-dimethyl(meth)acrylamide, N-butyl(meth)acrylamide, N-methylol(meth)acrylamide and N-methylolpropane(meth)acrylamide; aminoalkyl (meth)acrylate-based monomers such as aminoethyl (meth)acrylate, N,N-dimethylaminaethyl (meth)acrylate and t-butylaminoethyl (meth)acrylate; alkoxyalkyl (meth)acrylate-based monomers such as methoxyethyl (meth)acrylate and ethoxyethyl (meth)acrylate; maleimide-based monomers such as N-cyclohexylmaleimide, N-isopropylmaleimide, N-laurylmaleimide and N-phenylmaleimide; itaconimide-based monomers such as N-methylitaconimide, N-ethylitaconimide, N-butylitaconimide, N-octylitaconimide, N-2-ethylhexylitaconimide, N-cyclohexylitaconimide, and N-laurylitaconimide; succinimide-based monomers such as N-(meth)acryloyloxymethylenesuccinimide, N-(meth)acryloyl-6-oxyhexamethylenesuccinimide and N-(meth)acryloyl-8-oxyoctamethylenesuccinimide; vinylic monomers such as vinyl acetate, vinyl propionate, N-vinylpyrrolidone, methylvinylpyrrolidone, vinylpyridine, vinylpiperidone, vinylpyrimidine, vinylpiperazine, vinylpyrazine, vinylpyrrole, vinylimidazole, vinyloxazole, vinylmorpholine, N-vinylcarboxylic amides, styrene, α-methylstyrene and N-vinylcaprolactam; cyanoacrylate monomers such as acrylonitrile and methacrylonitrile; epoxy group-containing acrylic monomers such as glycidyl (meth)acrylate; glycolic acrylate ester monomers such as polyethylene glycol (meth)acrylate, polypropylene glycol (meth)acrylate, methoxyethylene glycol (meth)acrylate and methoxypolypropylene glycol (meth)acrylate; acrylate ester-based monomers having a heterocycle, a halogen atom, a silicon atom or the like, such as tetrahydrofurfuryl (meth)acrylate, fluoro(meth)acrylate and silico(meth)acrylate; polyfunctional monomers such as hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylate, polyester acrylate and urethane acrylate; olefinic monomers such as isoprene, butadiene and isobutylene; and vinyl etheric monomers such as vinyl ether. These monomer components may be used singly or in combination of two or more.

The tackiness agent described above is more preferably a tackiness agent containing as a base a polymer whose dynamic elastic modulus at room temperature to 150°C is in the range of 50,000 to 10,000,000 dyn/cm² from the viewpoint of the balance between a proper adhesive force before the heat treatment and a decrease in the adhesive force after the heat treatment.

### (Coloring agent)

A coloring agent usable is a pigment, a dye or the like.

Examples of organic pigments of the pigment include acrylic pigments, azo-based pigments, polyazo-based pigments, anthraquinone-based pigments, quinacridone-based pigments, isoindoline-based pigments, isoindolinone-based pigments, phthalocyanine-based pigments, perylene-based pigments, DPP-based pigments, fluorescent pigments, condensed polycyclic pigments and colored resin particles, and examples of inorganic pigments include well-known pigments such as carbon black, synthetic silica, chromium oxide, iron oxide, titanium oxide, zinc sulfide, calcined pigments and natural mica.

As the dye, well-known dyes in any form can be used such as acid dyes, reactive dyes, direct dyes, disperse dyes, cationic dyes and polymer dyes.

If a pigment or a dye strong in coloring power is used out of these coloring agents, coloring can be carried out in nearly the same degree by a smaller amount added also in making the coloring agent contained in a thermally expansive pressure-sensitive adhesive layer. Further if a pigment or a dye having no metal element or having metal elements firmly bonded in such a degree that the metal elements do not separate in the coloring agent is employed, the amount of the metal elements deposited on workpiece surfaces during use can be reduced.

The concentration of a coloring agent in a thermally expansive pressure-sensitive adhesive layer is 0.01 to 1.5 parts by weight, and preferably 0.3 to 1.0 part by weight, with respect to 100 parts by weight of a tackiness agent base polymer constituting the thermally expansive pressure-sensitive adhesive layer 3. If in this range, a heat-peelable adhesive sheet can be obtained which is colored in such a degree that users can visually recognize, and from which the coloring agent or the metal elements from the coloring agent do not deposit on workpieces.

### (Thermally expansive microsphere)

A thermally expansive microsphere suffices if being, for example, a microsphere in which a substance such as isobutane, propane or pentane which is easily gasified and expands by heating is included in a shell having elasticity. The shell is usually formed of a thermoplastic substance, a thermally melting substance, a substance to burst by thermal expansion, or the like. Examples of substances to form the shell include vinylidene chloride-acrylonitrile copolymers, polyvinyl alcohols, polyvinyl butyrals, polymethyl methacrylates, polyacrylonitriles, polyvinylidene chlorides and polysulfones. The thermally expansive microsphere can be produced by a commonly-used method, for example, the coacervation method or the interfacial polymerization method. As the thermally expansive microsphere, commercially available products, for example, Matsumoto Microsphere (trade name, made by Matsumoto Yushi-Seiyaku Co., Ltd.), can also be utilized.

The average particle diameter of a thermally expansive microsphere is commonly about 1 to 80 µm, and preferably about 3 to 50 µm, from the viewpoint of the dispersibility, the thin-layer formability and the like. The thermally expansive microsphere, in order to efficiently reduce the pressure-sensitive adhesive force of a thermally expansive pressure-sensitive adhesive layer containing a tackiness agent by a heat treatment, is preferably one having such a proper strength that the microsphere does not burst until the volume expansion coefficient becomes 5 or more times, especially preferably 10 or more times. In the case of using a thermally expansive microsphere to burst at a low expansion coefficient, and in the case of using a thermally expansive agent having not been microcapsulated, the pressure-sensitive adhesive area between the pressure-sensitive adhesive layer 3 and a workpiece is not sufficiently reduced, hardly providing a good peelability.

The amount of a thermally expansive microsphere used is, depending on the kind thereof, for example, 10 to 200 parts by weight, preferably 20 to 125 parts by weight, and more preferably 20 to 50 parts by weight, with respect to 100 parts by weight of a tackiness agent base polymer constituting the thermally expansive pressure-sensitive adhesive layer 3. If the amount is smaller than 10 parts by weight, an effective reduction of the pressure-sensitive adhesive force after the heat treatment is liable to become insufficient; and if the amount exceeds 200 parts by weight, the cohesive break of the thermally expansive pressure-sensitive adhesive layer 3, and in the case where an intermediate layer is provided on the substrate, the interfacial break between the thermally expansive pressure-sensitive adhesive layer 3 and the intermediate layer are liable to be caused.

To the thermally expansive pressure-sensitive adhesive layer 3, in addition to a tackiness agent and a thermally expansive microsphere, suitable additives may be blended such as a crosslinking agent (for example, a polyisocyanate or an alkyl etherified melamine compound), a tackifier (for example, a polyfunctional epoxy compound, an isocyanate compound, an aziridine compound, a melamine resin, a rosin derivative resin, a polyterpene resin, a petroleum resin, an oil-soluble phenol resin, a urea resin, an anhydride compound, a polyamine or a carboxyl group-containing polymer), a plasticizer, a pigment, a filler, an antiaging agent, a surfactant and an antistatic agent.

### [Intermediate layer]

An intermediate layer in the present invention is a layer to improve the adhesiveness between a substrate and a thermally expansive pressure-sensitive adhesive layer, and to hold the thermally expansive pressure-sensitive adhesive layer against a shearing force and a pressing force applied on the thermally expansive pressure-sensitive adhesive layer in processing a workpiece in use of a heat-peelable adhesive sheet to thereby stably process the workpiece with no displacement of the workpiece, and also a layer to color the heat-peelable adhesive sheet itself by incorporation of a coloring agent, and to prevent the pollution of the workpiece surface with metal ions and the like by reduction of the amount of the coloring agent contained in the thermally expansive pressure-sensitive adhesive layer being a surface layer and being adhered to the workpiece.

Such an intermediate layer comprises a material which is excellent in the tight adhesiveness between a substrate and a thermally expansive pressure-sensitive adhesive layer and has higher elastic modulus and hardness than the thermally expansive pressure-sensitive adhesive layer, and for example, an energy-ray curing type resin, a resin having a large cohesive force out of tacky substances usable for the thermally expansive pressure-sensitive adhesive layer, and the like can be used.

The energy-ray curing type resin contains an energy-ray curing compound (or an energy-ray curing resin) to impart energy-ray curability, and has a viscoelasticity in such a degree that convexoconcaves of the thermally expansive microspheres can be reduced when the thermally expansive pressure-sensitive adhesive layer 3 is press bonded. The energy-ray curing type resin is preferably one becoming an elastic body after energy-ray irradiation. From these viewpoints, the intermediate layer using the energy-ray curing type resin is preferably constituted of a composition in which an energy-ray curing compound (or an energy-ray curing resin) is blended in a base material having an elasticity.

The base material is preferably one in which an energy-ray curing type resin is mixed in the tacky substance described above, thereby allowing to impart physical properties necessary for the intermediate layer.

An energy-ray curing compound to cure an energy-ray curing type resin layer with energy rays is not especially limited as long as being capable of curing with energy rays such as visible light rays, ultraviolet rays and electron beams, but is preferably an energy-ray curing compound which efficiently makes the three-dimensional network in the energy-ray curing type resin layer after energy-ray irradiation. The energy-ray curing compound may be used singly or in combinations of two or more.

Specific examples of the energy-ray curing compound include trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, 1,4-butylene glycol diacrylate, 1,6-hexanediol diacrylate and polyethylene glycol diacrylate.

An energy-ray curing resin may be used as an energy-ray curing compound, and examples of the energy-ray curing resin include ester (meth)acrylates having a (meth)acryloyl group on the molecular terminal, urethane (meth)acrylates, epoxy (meth)acrylates, melamine (meth)acrylates, acrylic resin (meth)acrylates, thiol-ene addition type resins or cationic photopolymerization type resins having an allyl group on the molecular terminal, cinnamoyl group-containing polymers such as polyvinyl cinnamates, diazotized amino novolac resins, acrylamide type polymers and the like, and photosensitive reactive group-containing polymers or oligomers. Polymers reacting by high energy rays further include epoxidized polybutadienes, unsaturated polyesters, polyglycidyl methacrylates, polyacrylamides and polyvinylsiloxanes.

Here, the case where an energy-ray curing resin is used does not necessarily need the base material described above.

The amount of an energy-ray curing compound blended is, for example, in the range of about 5 to 500 parts by weight, preferably 15 to 300 parts by weight, and more preferably about 20 to 150 parts by weight, with respect to 100 parts by weight of a base material. If the dynamic elastic modulus of an intermediate layer comprising an energy-ray curing type resin layer after energy-ray irradiation is 5 × 10⁶ to 1 × 10¹⁰ Pa (frequency: 1 Hz, sample: film-shape of 1.5 mm in thickness) in a shear storage elastic modulus at 20°C, excellent cutting workability and heat peelability can be simultaneously satisfied. The storage elastic modulus can be regulated by suitably selecting the kind and the amount of an energy-ray curing compound blended, the energy-ray irradiation condition and the like.

Here, as required, an energy-ray polymerization promoter may be used concurrently with the energy-ray polymerization initiator.

Since the layer thickness of a thermally expansive pressure-sensitive adhesive layer can be made thinner by providing such an intermediate layer, the thin film thickness can hold stably a workpiece when the workpiece is processed.

The incorporation of a coloring agent in the intermediate layer itself, even in the case where metal ions are generated from the intermediate layer, blocks the metal ions at the interface between the intermediate layer and a thermally expansive pressure-sensitive adhesive layer, thereby causing no pollution to the workpiece surface after use.

To the intermediate layer, in addition to the components described above, there may be blended an energy-ray polymerization initiator to cure an energy-ray curing compound, suitable additives such as a thermal polymerization initiator, a crosslinking agent, a tackifier and a vulcanizer to provide a suitable viscoelasticity before and after energy-ray curing, and as required, further a filler, an antiaging agent, an antioxidant and a coloring agent.

As the energy-ray polymerization initiator, a well-known and commonly-used polymerization initiator can suitably be selected according to the kind of energy rays to be used.

In the case where polymerization and curing are carried out using ultraviolet rays as energy rays, a photopolymerization initiator is contained for curing. The photopolymerization initiator is not especially limited, but examples thereof include benzoin ethers such as benzoin methyl ether, benzoin isopropyl ether and 2,2-dimethoxy-1,2-diphenylethan-1-one; substituted benzoin ethers such as anisole methyl ether; substituted acetophenones such as 2,2-diethoxyacetophenone, 2,2-dimethoxy-2-phenylacetophenone and 1-hydroxy-cyclohexylphenyl ketone; substituted alpha-ketols such as 2-methyl-2-hydroxypropiophenone; aromatic sulfonyl chlorides such as 2-naphthalenesulfonyl chloride; photoactive oximes such as 1-phenyl-1,1-propanedione-2-(o-ethoxycarbonyl)-oxime; and acylphosphine oxides such as 2,4,6-trimethylbenzoyl-diphenyl-phosphine oxide and bis(2,4,6-trimethylbenzoyl)-phenylphosphine oxide.

### (Formation of the thermally expansive pressure-sensitive adhesive layer)

The thermally expansive pressure-sensitive adhesive layer 3 can be formed by a suitable method including a method in which a coating liquid containing, for example, a tackiness agent, a coloring agent, a thermally expansive microsphere, and as required, additives, a solvent and the like is applied on the substrate or through the intermediate layer 2 provided on the substrate 1, and press bonded through a separator 4, and a method in which the coating liquid is applied on a suitable separator (peeling paper or the like) 4 to thereby form the heat-peelable tackiness agent layer 3, which is press bonded and transferred (transferred and bonded) on the substrate 1 or the intermediate layer 2 provided on the substrate.

The separator 4 is a sheet made by forming, as required, a peeling agent layer on one side of a substrate film, and is a sheet protecting a surface layer of the heat-peelable adhesive sheet according to the present invention, and peeled before use to expose the surface layer, and may be a sheet becoming a foundation when a thermally expansive pressure-sensitive adhesive layer is formed.

As a substrate film of the separator 4, well-known ones can be used; and the substrate film can be selected from plastic films and the like, for example, polyether ether ketones, polyether imides, polyarylates, polyethylene naphthalates, polyethylene films, polypropylene films, polybutene films, polybutadiene films, polymethylpentene films, polyvinyl chloride films, vinyl chloride copolymer films, polyethylene terephthalate films, polybutylene terephthalate films, polyurethane films, ethylene-vinyl acetate copolymer films , ionomer resin films, ethylene-(meth)acrylic acid copolymer films, ethylene-(meth)acrylate ester copolymer films, polystyrene films and polycarbonate films.

A peeling agent layer usable is a layer in which a fluorinated silicone resin-based peeling agent, a fluororesin-based peeling agent, a silicone resin-based peeling agent, or a well-known peeling agent such as of a polyvinyl alcoholic resin, a polypropylenic resin or a long-chain alkyl compound is selected and contained according to a resin of the tackiness agent layer.

The thickness of the thermally expansive pressure-sensitive adhesive layer 3, although it can be determined suitably according to the use purpose of a pressure-sensitive adhesive sheet, the reduction of the pressure-sensitive adhesive force due to heating, and the like, is preferably set at the maximum diameter or a smaller one of the thermally expansive microsphere in order to retain the smoothness of the surface. Therefore, the thickness of the thermally expansive pressure-sensitive adhesive layer 3 is 80 µm or smaller, preferably 50 µm or smaller, and more preferably 20 µm or smaller. In the case where the thermally expansive pressure-sensitive adhesive layer 3 is formed on the intermediate layer 2, and if the thickness of the thermally expansive pressure-sensitive adhesive layer 3 is 50 µm or smaller, a sufficient pressure-sensitive adhesive force to hold workpieces can be provided; and although a pressing force and a shearing force are applied also on the thermally expansive pressure-sensitive adhesive layer 3 through these forces applied on electronic components in processing the electronic components, since the thickness of the thermally expansive pressure-sensitive adhesive layer 3 is small, the heat-peelable adhesive sheet according to the present invention can securely hold the electronic components against the applied forces.

The separator 4 usable is, for example, a substrate composed of a plastic film, a paper or the like whose surface is coated with a peeling agent represented by a silicone-based resin, a long-chain alkyl acrylate-based resin, a fluororesin or the like, or a substrate composed of a nonpolar polymer such as polyethylene or polypropylene and having low pressure-sensitive adhesiveness.

The separator 4, as described above, is used as a temporary support when the thermally expansive pressure-sensitive adhesive layer 3 is press bonded and transferred (transferred and bonded) on the intermediate layer 2, and as a protecting material to protect the thermally expansive pressure-sensitive adhesive layer 3 until actual use.

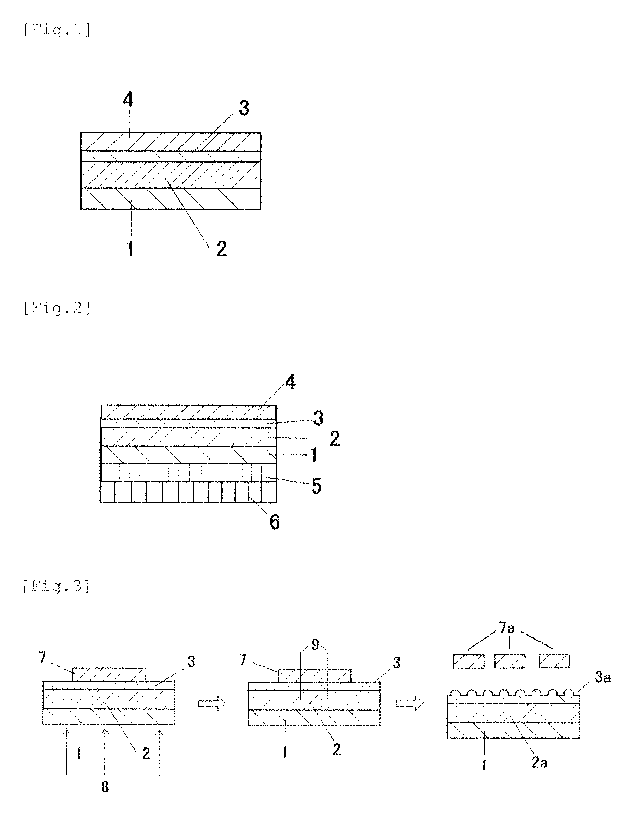

The intermediate layer 2 and the thermally expansive pressure-sensitive adhesive layer 3 may be formed not only on one side of the substrate 1 but also on both sides thereof. Figure 2 is a schematic cross-sectional diagram showing another example of the heat-peelable adhesive sheet according to the present invention.

As shown in Figure 2, the thermally expansive pressure-sensitive adhesive layer 3 is provided on one side of the substrate 1, as required, through the intermediate layer 2, and a usual adhesive agent layer 5 may be provided on the other side thereof. In order to prevent fine cohesive break accompanying the convexoconcave deformation of the thermally expansive pressure-sensitive adhesive layer 3 at the adhesive interface between the thermally expansive pressure-sensitive adhesive layer 3 and a workpiece during the heat treatment, a pressure-sensitive adhesive layer may be further provided on the thermally expansive pressure-sensitive adhesive layer 3. As a tacky substance of the pressure-sensitive adhesive layer, the tackiness agent described in the above-mentioned thermally expansive pressure-sensitive adhesive layer 3 can be used. The thickness of the pressure-sensitive adhesive layer is preferably 0.1 to 8 µm, and especially preferably 1 to 5 µm, from the viewpoint of the reduction or the loss of the pressure-sensitive adhesive force to workpieces; and the pressure-sensitive adhesive layer can be formed by a method according to the case of the thermally expansive pressure-sensitive adhesive layer 3.

In the example of Figure 2, on one side of the substrate 1, the intermediate layer 2, the thermally expansive pressure-sensitive adhesive layer 3 and the separator 4 are laminated on this order; and on the other side of the substrate 1, the adhesive agent layer 5 and a separator 6 are laminated. This pressure-sensitive adhesive sheet is different from the pressure-sensitive adhesive sheet in Figure 1 only in the point that the adhesive agent layer 5 and the separator 6 are provided on the side of the substrate 1 opposite to the side thereof on which the intermediate layer 2 and the heat-peelable type tackiness agent layer 3 thereon are provided.

The adhesive agent layer 5 contains a tacky substance. As the tacky substance, the same tacky substance (tackiness agent) as in the thermally expansive pressure-sensitive adhesive layer 3 can be used; and as required, suitable additives may be blended such as a crosslinking agent (for example, a isocyanate-based crosslinking agent or an epoxy-based crosslinking agent), a tackifier (for example, a rosin derivative resin, a polyterpene resin, a petroleum resin, or an oil-soluble phenol resin), a plasticizer, a filler, an antiaging agent, and a surfactant. However, use or addition of substances remarkably inhibiting the transmission of energy rays to cure an energy-ray curing type resin layer is not preferable.

The thickness of the adhesive agent layer 5 can suitably be set in the range not damaging the operability in press bonding of the thermally expansive pressure-sensitive adhesive layer 3 on workpieces, cutting of workpieces, peeling and recovery of cut pieces, and the like, but is usually 1 to 50 µm, and preferably about 3 to 30 µm.

The formation of the adhesive agent layer 5 can be carried out by a method according to the case of the thermally expansive pressure-sensitive adhesive layer 3. As the separator 6, the same separator as the separator 4 on the thermally expansive pressure-sensitive adhesive layer 3 can be used. Such a pressure-sensitive adhesive sheet can be fixed and used on a pedestal surface by utilizing the adhesive agent layer 5.

### [Method for producing a heat-peelable adhesive sheet]

As required, a composition to form the intermediate layer 2 is uniformly applied on one side or both sides of the substrate 1 by optional means. Then, in the case where the obtained intermediate layer 2 formed on one side or both sides of the substrate 1 is of an energy-ray curing type, and in the case where the intermediate layer 2 contains a solvent excluding a reactive solvent, the intermediate layer 2 is made to be in the state that the solvent has been removed by drying, and to be an intermediate layer before curing with energy rays. However, the intermediate layer 2 may be partially cured as far as having sufficient fluidity.

In the case where the intermediate layer 2 is not of an energy-ray curing type, a composition to form the intermediate layer 2 is applied and dried.

The thermally expansive pressure-sensitive adhesive layer 3 is separately formed which has been applied and dried on a separator prepared. Since the contained thermally expansive microspheres are not completely buried in the thermally expansive pressure-sensitive adhesive layer, parts of the thermally expansive microspheres protrude and form convex parts on the surface of the thermally expansive pressure-sensitive adhesive layer, that is, the surface not on the separator side.

The thermally expansive pressure-sensitive adhesive layer 3 formed on the separator 4 is laminated on the surface of the intermediate layer 2 before curing so that the surface having the convex parts formed on the thermally expansive pressure-sensitive adhesive layer 3 is joined; and by pressing mutually the intermediate layer 2 and the thermally expansive pressure-sensitive adhesive layer 3 from the substrate 1 side and the separator 4 side, respectively, the convex parts are made to be buried inside the uncured intermediate layer.

As a result, a sheet is provided which is made by laminating the substrate 1, the uncured intermediate layer 2, the thermally expansive pressure-sensitive adhesive layer 3 and the separator 4 in this order.

Further by curing the uncured intermediate layer 2 by irradiating the uncured intermediate layer 2 with energy rays from the substrate 1 side and/or the separator 4 side to thereby obtain the heat-peelable adhesive sheet according to the present invention.

Of course, without using the separator 4, a thermally expansive tackiness agent may be applied and dried directly on the substrate 1.

The method for producing a heat-peelable adhesive sheet is a method in which the intermediate layer 2 and the thermally expansive pressure-sensitive adhesive layer 3 are provided on one side of the substrate 1; but in the case where the intermediate layer 2 and the thermally expansive pressure-sensitive adhesive layer 3 are provided on each of both sides of the substrate 1, the method may be carried out successively for each side of the substrate, or may be carried out simultaneously for both sides of the substrate. In the case where the adhesive agent layer 5 is provided on the other side of a substrate, the formation of the adhesive agent layer 5 may be carried out in either stage of before or after the step of providing the intermediate layer 2 and the thermally expansive pressure-sensitive adhesive layer 3.

### [Method for using the heat-peelable adhesive sheet]

Figure 3 is a schematic process diagram showing one example of the production method of cut pieces using the heat-peelable adhesive sheet according to the present invention. In more detail, Figure 3 is a process diagram showing in cross-sectional diagrams a series of processes of press bonding and sticking a workpiece 7 on the side of the thermally expansive pressure-sensitive adhesive layer 3 of the heat-peelable adhesive sheet (in the state where the separator 4 is peeled) in Figure 1, curing the intermediate layer 2 by irradiation of energy rays 8 and the like, thereafter cutting the workpiece along cutting lines 9 into predetermined sizes to make cut pieces, then expanding and foaming a thermally expansive microsphere in the thermally expansive pressure-sensitive adhesive layer 3 by a heat treatment, and recovering cut pieces 7a. Alternatively, after the intermediate layer 2 is cured by irradiation of the energy rays 8, the workpiece 7 may be press bonded and stuck on the side of the thermally expansive pressure-sensitive adhesive layer 3, and cut along the cutting lines 9.

Applications of the heat-peelable adhesive sheet according to the present invention are not limited to such cutting, and are general processing processes including grinding and boring.

In Figure 3, reference numeral 1 denotes a substrate; reference numeral 2a denotes an intermediate layer cured after energy-ray irradiation; and reference numeral 3a denotes a thermally expansive pressure-sensitive adhesive layer after a thermally expansive microsphere is expanded further by heating after energy-ray irradiation. The press bonding of the thermally expansive pressure-sensitive adhesive layer 3 of the heat-peelable adhesive sheet and the workpiece 7 can be carried out by a system of press bonding treatment by suitable pressing means, for example, a rubber roller, a laminate roll or a press machine, or by other systems. In the press bonding treatment, if needed, according to the type of a tacky substance, the heat-peelable adhesive sheet may be heated in such a temperature range that the thermally expansive microsphere does not expand, or the tacky substance may be activated by applying water or an organic solvent.

The energy rays 8 usable are visible light rays, ultraviolet rays, electron beams and the like. The irradiation of the energy rays 8 can be carried out by a suitable method. However, since the thermally expansive microsphere starts to expand due to the irradiation heat of the energy rays 8 in some cases, it is desirable that the irradiation is restricted in as short a time as possible, or the temperature is held at a temperature at which the thermally expansive microsphere does not start to expand by air cooling or otherwise the heat-peelable adhesive sheet.

The cutting of the workpiece 7 can be carried out by commonly-used cutting means such as dicing. The heating condition can suitably be set according to the surface condition and the heat resistance of the workpiece 7 (or the cut pieces 7a), the kind of the thermally expansive microsphere, the heat resistance of the pressure-sensitive adhesive sheet, the heat capacity of the workpiece and the like, but is generally a temperature of 350°C or lower, and a treatment time of 30 min or shorter, and especially preferably a temperature of 80 to 200°C and a treatment time of about 1 sec to 15 min. The heating system includes a hot air heating system, a hot plate contact system and an infrared heating system, but is not especially limited.

In the case of using a substrate having stretchability as the substrate 1 of the pressure-sensitive adhesive sheet, the stretch treatment can be carried out, for example, by commonly-used stretch means used in two-dimensional stretch of sheets.

Since the heat-peelable adhesive sheet according to the present invention comprises the thermally expansive pressure-sensitive adhesive layer 3 containing the tacky substance (tackiness agent), the workpiece 7 can be firmly held, and is not peeled, for example, by vibrations and the like during transportation. Since the thermally expansive pressure-sensitive adhesive layer 3 can be formed thin, and the intermediate layer 2 is cured before the cutting process, while chipping and the like accompanying winding-up of an adhesive agent layer and movement of the adhesive agent layer and the like by a cutting blade in the cutting step are more largely reduced than in the case of conventional thermally expansive pressure-sensitive adhesive sheets, the workpiece can be cut into predetermined sizes. Further since the thermally expansive pressure-sensitive adhesive layer 3 contains the thermally expansive microsphere, and has the thermal expansion property, the heat treatment after the cutting step rapidly foams and expands the thermally expansive microsphere, and changes the volume of the thermally expansive pressure-sensitive adhesive layer 3 to thereby form a convexoconcave three-dimensional structure, thus leading to a remarkable reduction or loss of the adhesive area and in its turn, the adhesive strength between the thermally expansive pressure-sensitive adhesive layer 3 and the cut pieces 7a. Thus, a remarkable reduction or loss of the adhesive strength by the curing of the intermediate layer 2 and the heat treatment largely improves the operability and workability in the cutting step of the workpiece 7, and the peeling and recovery step of the cut pieces 7a, and largely improves the production efficiency.

Although the heat-peelable adhesive sheet according to the present invention can be used for applications of permanently adhering workpieces, the heat-peelable adhesive sheet is suitable for applications in which workpieces are adhered for a predetermined period, and after the adhesion purpose has been achieved, the relief of the adhesion state is required or desired. Specific examples of such applications include fixing materials for semiconductor wafers and ceramic laminate sheets, additionally, carrier tapes, temporary fixing materials or fixing materials for components conveyance, temporary fixing or the like in assembly processes of various types of electric devices, electronic devices, display devices and the like, and surface protection materials, masking materials or the like for the purpose of pollution and damage prevention, such as metal plates, plastic plates, glass plates and the like. Especially in the manufacture process of electronic components, the heat-peelable adhesive sheet can suitably be used in the manufacture processes of small or thin-layer semiconductor chips and multilayer capacitor chips.

### [Examples]

### (Example 1)

A heat-peelable adhesive sheet of Example 1 was fabricated by the following procedure.

First, a toluene solution containing 100 parts by weight of 2-ethylhexyl acrylate - ethyl acrylate - methyl methacrylate (polymerized in the proportion of 30, 70, 5 parts by weight, respectively) copolymer-based tackiness agent (1 part by weight of an isocyanate-based crosslinking agent was blended) was adjusted, and applied on a polyester film of 100 µm in thickness to become a substrate so that the thickness of the solution after drying became about 15 µm, to thereby obtain a rubbery organic elastic layer.

Then, a toluene solution in which 30 parts by weight of Matsumoto Microsphere F-501D (trade name, made by Matsumoto Yushi-Seiyaku Co., Ltd.) and 0.01 part by weight of a metal element-containing solid pigment were blended in 100 parts by weight of 2-ethylhexyl acrylate - ethyl acrylate - methyl methacrylate copolymer-based tackiness agent (2 parts by weight of an isocyanate-based crosslinking agent was blended) was adjusted, and applied on a separator so that the thickness of the solution after drying became about 35 µm, to thereby obtain a thermally expansive pressure-sensitive adhesive layer.

Finally, the surface of the thermally expansive pressure-sensitive adhesive layer was laminated on the rubbery organic elastic layer on the polyester film to thereby fabricate a heat-peelable adhesive sheet of Example 1.

### (Example 2)

A heat-peelable adhesive sheet of Example 2 was obtained as in Example 1, except for blending 0.5 parts by weight of the metal element-containing solid pigment in place of blending 0.01 part by weight thereof.

### (Example 3)

A heat-peelable adhesive sheet of Example 3 was obtained as in Example 1, except for blending 0.8 parts by weight of the metal element-containing solid pigment in place of blending 0.01 part by weight thereof.

### (Example 4)

A heat-peelable adhesive sheet of Example 4 was obtained as in Example 1, except for blending 1.0 part by weight of the metal element-containing solid pigment in place of blending 0.01 part by weight thereof.

### (Comparative Example 1)

A heat-peelable adhesive sheet of Comparative Example 1 was fabricated by the same method as in Example 1, except for blending 3.0 parts by weight of the solid pigment.

The amount of metal transferred of the pressure-sensitive adhesive sheet to a workpiece (in this evaluation, a pressure-sensitive adhesive sheet to which a pigment containing copper phthalocyanine is added was used) was quantified by ICP-MS (Inductively Coupled Plasma Mass Spectroscopy) (the measurement method is as follows).

First, the pressure-sensitive adhesive sheet was laminated on a silicon wafer (mirror surface, 100 mm thick) used in manufacture of semiconductors, and press bonded by a 2-kg constant-load rubber roller. The resultant was left at 40°C for 1 day, and thereafter, the pressure-sensitive adhesive sheet was peeled by thermal foaming. Then, the whole amount of an oxidized film on the sheet-peeled surface side of the silicon wafer was etched with a proper hydrofluoric acid. The whole amount of a liquid obtained by the etching was gathered in an evaporating dish, and heated and evaporated to dryness; and the residue was dissolved in an acid to thereby obtain a measurement sample liquid. The obtained sample liquid was measured by ICP-MS. An element mass (n g) obtained by the measurement was divided by the atomic weight of Cu to be converted to a molar number, which value was multiplied by Avogadro's number to be converted to the number of atoms, which value was divided by an area of the etched silicon wafer to be thereby converted to the number of atoms per unit area (atoms/cm²).

The obtained results are shown below.

**[Table 1]**

| | Pigment Pollution | Cu Ion Amount by ICP |
|---|---|---|
| Example 1 | No deposition of pigment | Detection limit (0.24 × 10¹⁰ atoms/cm²) or below |
| Example 2 | No deposition of pigment | Detection limit or below |
| Example 3 | No deposition of pigment | Detection limit or below |
| Example 4 | No deposition of pigment | Detection limit or below |
| Comparative Example 1 | No deposition of pigment | 2.1×10¹⁰ atoms/cm² |

In Examples described above, the copper transfer amounts of the sheet-peeled surfaces were confirmed to be the detection limit or below in ICP-MS. With respect to the measurement values described above, techniques for judging that the pollution or deposition originated from metal elements were substantially absent or almost absent include the measurement in which the metal element-containing pressure-sensitive adhesive sheets were applied to the semiconductor workpieces, and peeled; and thereafter, the transferred substances to the semiconductor workpieces (for example, mirror surfaces of the silicon wafers) were measured by ICP-MS and the metals on the surfaces of the semiconductor workpieces were 1.0 × 10¹⁰ atoms/cm² or lower.

From the above, the addition of a pigment could improve the visibility and the distinguishability; the restriction of the amount of a pigment added secured an enough transmittance to check the sticking of a sheet; and the pollution to a material to be stuck on due to metal elements could be suppressed to the minimum. Therefore, also in the case where workpieces are electronic components, there is no possibility that the electronic components are adversely affected by the pollution with metal ions.

Further, even if the kinds of pigments are changed, the heat-peelable adhesive sheets have the same properties. Therefore, heat-peelable adhesive sheets exhibiting various colors are prepared, and a suitable heat-peelable adhesive sheet can be selected and used by distinguishing between the colors thereof corresponding to the kind of a workpiece.

**[Table 2]**

| | | | Example 1 | Example 2 | Example 3 | Example 4 | Comparative Example 1 |
|---|---|---|---|---|---|---|---|
| Acrylic Pressure-Sensitive Adhesive Agent Composition | | parts | 100 | 100 | 100 | 100 | 100 |
| Pigment | | parts | 0.01 | 0.5 | 0.8 | 1.0 | 3.0 |
| Total Light Transmittance | | % | 83.9 | 68.4 | 62.6 | 58.3 | 31.7 |
| ICP-MS (Copper Transfer Amount) | | atoms/ cm² | Detection limit or below | Detection limit or below | Detection limit or below | Detection limit or below | 2.1×10¹⁰ |
| | After thermal peeling | | Detection limit or below | Detection limit or below | Detection limit or below | Detection limit or below | 2.4×10¹⁰ |

## Claims

1. A heat-peelable adhesive sheet, comprising:
a thermally expansive pressure-sensitive adhesive layer that contains a thermally expansive microsphere and a coloring agent and that is provided on one side or both sides of a substrate; or
a thermally expansive pressure-sensitive adhesive layer that contains a thermally expansive microsphere and that is provided on one side or both sides of a substrate through a colored intermediate layer, and
having a total light transmittance of 50% or more.

2. The heat-peelable adhesive sheet according to claim 1, wherein an amount of metal transferred to a workpiece after the heat-peelable adhesive sheet is stuck on a workpiece and peeled from the workpiece is 1.0 × 10¹⁰ atoms/cm² or lower as a measurement value by inductively coupled plasma mass spectroscopy.

3. The heat-peelable adhesive sheet according to claims 1 and 2, wherein an amount of metal transferred to a workpiece after the heat-peelable adhesive sheet is stuck to a workpiece, is left at 40°C for 1 day, and thereafter thermally peeled from the workpiece is 1.0 × 10¹⁰ atoms/cm² or lower as a measurement value by inductively coupled plasma mass spectroscopy.
